(19) **Europäisches Patentamt**
**European Patent Office**
**Office européen des brevets**

(11) **EP 2 233 934 B1**

(12) **EUROPEAN PATENT SPECIFICATION**

(45) Date of publication and mention
of the grant of the patent:
**21.12.2011 Bulletin 2011/51**

(51) Int Cl.:
*G01R 19/25* (2006.01)    *G01D 1/04* (2006.01)

(21) Application number: **10157018.2**

(22) Date of filing: **19.03.2010**

(54) **Current integrating circuit device and secondary battery package using the same**

Dispositif de circuit d'intégration de courant et ensemble de batterie secondaire l'utilisant

Stromintegrierende Schaltungsvorrichtung und Sekundärbatterieanordnung damit

(84) Designated Contracting States:
**AT BE BG CH CY CZ DE DK EE ES FI FR GB GR
HR HU IE IS IT LI LT LU LV MC MK MT NL NO PL
PT RO SE SI SK SM TR**

(30) Priority: **24.03.2009 JP 2009071808**

(43) Date of publication of application:
**29.09.2010 Bulletin 2010/39**

(73) Proprietor: **Kabushiki Kaisha Toshiba
Minato-ku
Tokyo (JP)**

(72) Inventors:
 • **Morikawa, Ryuichi
  Tokyo (JP)**
 • **Kubota, Masayuki
  Tokyo (JP)**
 • **Mizutani, Mami
  Tokyo (JP)**
 • **Monden, Yukitaka
  Tokyo (JP)**

 • **Kuwano, Yuki
  Tokyo (JP)**
 • **Tohara, Masahiro
  Tokyo (JP)**

(74) Representative: **HOFFMANN EITLE
Patent- und Rechtsanwälte
Arabellastraße 4
81925 München (DE)**

(56) References cited:
**EP-A1- 1 736 789     JP-A- 2001 343 403
JP-A- 2006 300 728     JP-A- 2007 155 598**

 • **"C-QV 715 Charge Integrating (Current
  Integrating) A/D Converter" Technoland
  Corporation no. Rev. 1.0a, 30 September 2007
  (2007-09-30), pages 1-2, XP002578338 Retrieved
  from the Internet: URL:http://www.tcnland.co.jp/
  Brochure/C-QV %20715%20R10a_E.pdf>
  [retrieved on 2010-04-19]**

EP 2 233 934 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**BACKGROUND OF THE INVENTION**

**Field of the Invention**

The present invention relates to a current integrating circuit device and a secondary battery package using the same, in which to integrate a current including a high frequency component is performed in high accuracy.

**Description of the Background**

In a secondary battery and a secondary battery package, to measure accurately a remaining amount of a battery capacity is required. As an effective method to obtain the remaining amount, a technique to integrate a current flowing in the secondary battery and to obtain the remaining amount by the integration value is known.

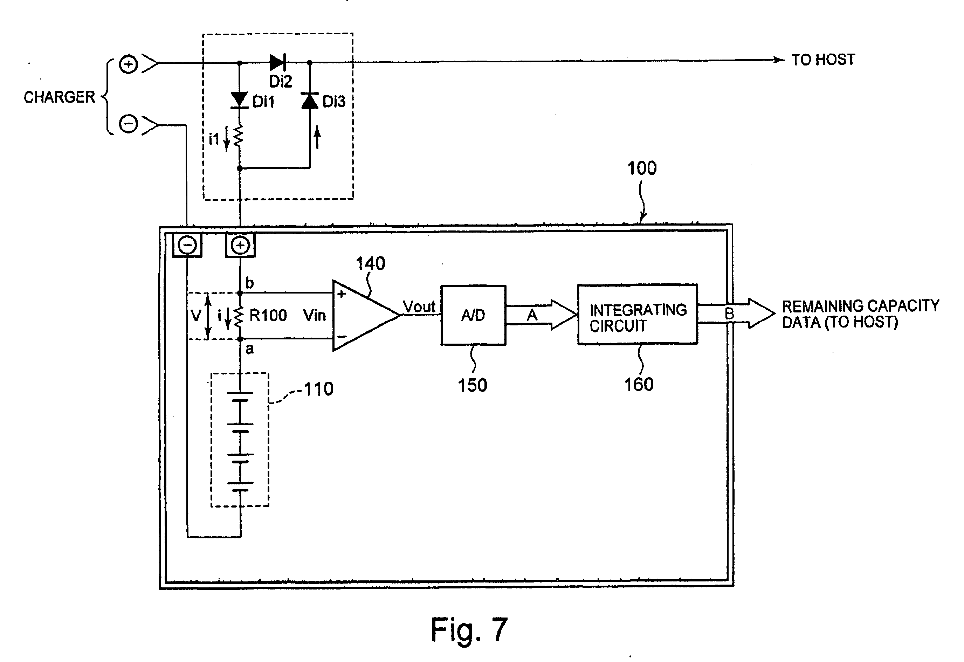

As such the technique, Patent Document 1 discloses a remaining capacity measuring device of a secondary battery package which can measure accurately a remaining amount of a battery capacity. Fig. 7 is a block diagram showing a construction of the remaining capacity measuring device.

A secondary battery 110 is stored in a secondary battery package 100. A current i flowing into the secondary battery 110 is determined by a charging current il supplied to the secondary battery 110 from a charger and a discharging current i2 discharged form the secondary battery 110 and supplied to a host apparatus. The current i is converted to a voltage V across terminals of a resistor R100. From the voltage across the terminals, a hexadecimal code A is generated at a predetermined sampling period by a differential amplifier 140 and an A/D converter 150. The hexadecimal code A is used to integrate the remaining capacity of the secondary battery 110. The hexadecimal code A is integrated by an integrating circuit 160 to generate a remaining capacity data B corresponding to the remaining capacity of the secondary battery 110. The remaining capacity data B is outputted to an external host apparatus.

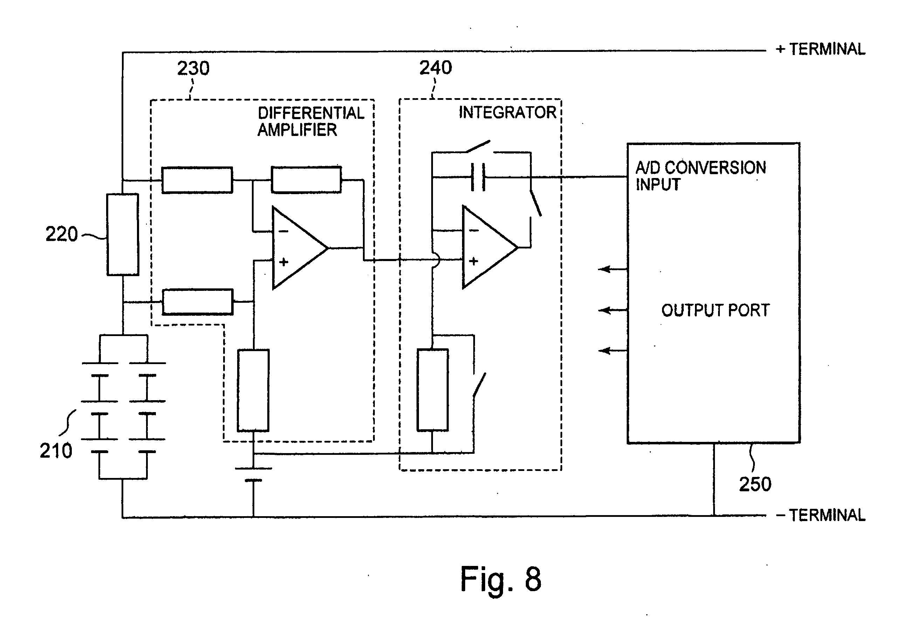

In addition, Patent Document 2 discloses a device to perform a method for detecting the charge and discharge of a secondary battery which can accurately measure a remaining capacity of the secondary battery even in case that the charging and discharging currents are pulse currents. As shown in Fig. 8, in the device, a current detecting resistor 220 is connected in series with a battery 210. A voltage across terminals of the current detecting resistor 220 is amplified using a differential amplifier 230. And an output of the differential amplifier 230 is amplified by an analog integrator 240 every definite period. A microcomputer 250 calculates charging and discharging currents using an integrated voltage outputted from the analog integrator 240. The microcomputer 250 calculates the remaining capacity by integrating the charging and discharging currents, and then displays the accurate remaining capacity.

Patent Document 1: Japanese Patent Disclosure (Kokai) PH5-26987
Patent Document 2: Japanese Patent Disclosure (Kokai) PH11-135156

But, according to the technique disclosed in Patent Document 1, there is a problem that in case of integrating a current including a higher frequency component than a sampling frequency, the accuracy of the current integration degrades. In particular, in case of a current which changes in a stepwise manner between the samplings, an error in the current integration becomes large. In order to reduce the error, it is necessary to make the sampling frequency high. But to do so, there arises a problem that a high-performance A/D converter and a high-performance calculating circuit with high processing abilities are required and thus the device becomes expensive.

In addition, according to the technique disclosed in Patent Document 2, as the current integrating processing is performed using a hardware and then A/D conversion is performed, the problem of the technique disclosed in Patent Document 1 is improved. But another problem arises that as the circuit construction becomes complicated and high precision parts are required for performing an accurate integration, the device becomes expensive.

JP2006300728 describes a photodetection circuit for detecting the amount of incident light onto a PMT with a wide dynamic range. For this purpose, a current signal is converted to a voltage signal, a dark current contribution is removed, the voltage signal is shaped via a delay filter circuit, A/D converted and then integrated. By adapting the integration time on the basis of the value of the digitized signal, the dynamic range can be increased.

EP 1 736 789 A1 relates to a method and equipment for estimating the residual capacity of a storage battery. For this purpose, as a first measurement procedure, the charging/discharging current is A/D converted and integrated. For attaining an improved measurement result, the document furthermore teaches to measure an open-circuit voltage in addition to the integration of the charging/discharging current.

SUMMARY OF THE INVENTION

Accordingly, an object of the present invention is to provide a current integrating circuit device and a secondary battery package using the current integrating circuit device which are inexpensive and can perform the current integration in high accuracy with simple construction.

According to an aspect of the present invention, there is provided a current integrating circuit device, including a current sensor to detect a current flowing through a current path, a first-order lag filter to filter an output of the current sensor, an A/D converter to convert an analog signal filtered by the first-order lag filter into a digital signal, and a proportional integrator to proportionally integrate the digital signal outputted from the A/D converter.

According to another aspect of the present invention, there is provided a secondary battery package, including the current integrating circuit device as described above, a secondary battery connected in series with the current sensor, and a remaining capacity estimating unit configured to estimate a remaining capacity of the secondary battery using a current integration result obtained by the proportional integrator in the current integrating circuit device.

According to the present invention, a current integrating circuit device and a secondary battery package using the current integrating circuit device can be provided which is inexpensive and can perform current integration in high accuracy with simple construction.

## BRIEF DESCRIPTION OF THE DRAWINGS

A more complete appreciation of the invention and many of the attendant advantages thereof will be readily obtained as the same becomes better understood by reference to the following detailed description when considered in connection with the accompanying drawings, wherein:

Fig. 1 is a block diagram showing a construction of a secondary battery package using a current integrating circuit device according to a first embodiment of the present invention;
Fig. 2 is a circuit diagram showing an example of a construction of the first-order lag filter 6 shown in Fig. 1,
Fig. 3 is a circuit diagram showing another example of a construction of the first-order lag filter 6 shown in Fig. 1;
Fig. 4 is a circuit diagram showing an example of a construction of the first-order lag filter 6 shown in Fig. 1 using an operational amplifier;
Fig. 5 is a drawing showing one example of a conventional current integration result;
Fig. 6 is a drawing showing one example of a current integration result of the current integrating circuit device according to the first embodiment;
Fig. 7 is a block diagram showing a construction of a remaining capacity measuring device of a secondary battery package as one example of a conventional current integrating circuit device; and
Fig. 8 is a block diagram showing a construction of a device to perform a method for detecting the charge and discharge of a secondary battery as another example of a conventional current integrating circuit.

## DETAILED DESCRIPTION OF THE INVENTION

Referring now to the drawings, wherein like reference numerals designate identical or corresponding parts throughout the several views, the embodiment of this invention will be described below.

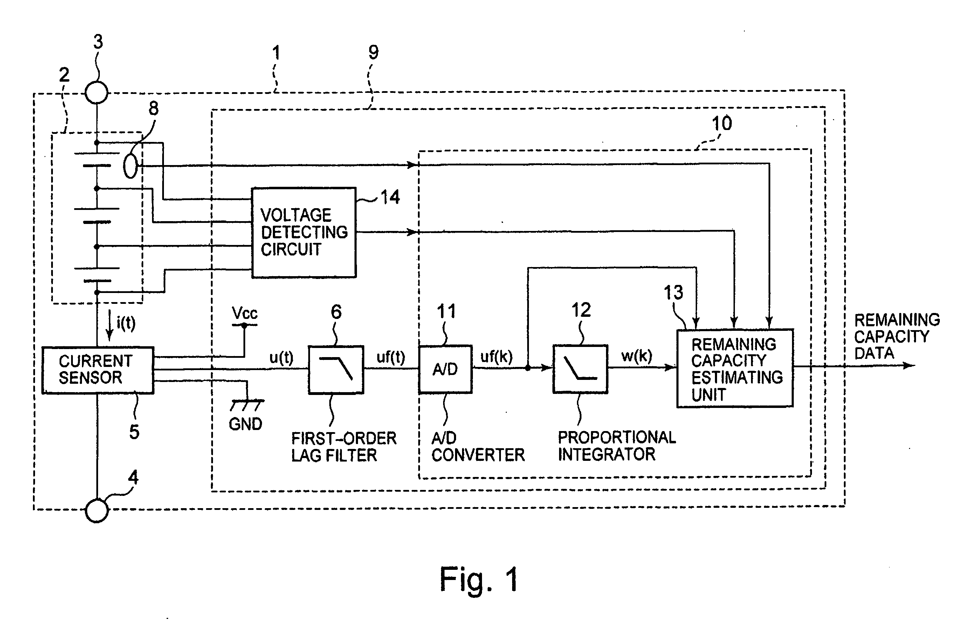

Fig. 1 is a block diagram showing a construction of a secondary battery package using a current integrating circuit device according to a first embodiment of the present invention. The secondary battery package is provided with a chassis 1, a secondary battery 2 accommodated in the chassis 1, a plus terminal 3 and a minus terminal 4 provided on the chassis 1, a current sensor 5 arranged between the secondary battery 2 and the minus terminal 4, and a control board 9. Here, a path between the secondary battery 2 and the minus terminal 4 corresponds to a current carrying path in the present invention.

On the control board 9, a first-order lag filter 6, a microcomputer 10 and a voltage detecting circuit 14 are loaded. The microcomputer 10 is provided with an A/D converter 11, a proportional integrator 12 and a remaining capacity estimating unit 13. A current integrating circuit device according to the embodiment of the present invention is composed of the current sensor 5, the first-order lag filter 6, the A/D converter 11 and the proportional integrator 12.

The secondary battery 2 is composed of a plurality of lithium ion battery cells which are connected in series. A positive electrode of the secondary battery 2 is connected to the plus terminal 3. A negative electrode of the secondary battery 2 is connected to the minus terminal via the current sensor 5. In case that the secondary battery package according to the first embodiment is loaded in a hybrid car and is used for engine assisting, for example, the plus terminal 3 and the minus terminal 4 are connected to DC terminals of an inverter for motor driving via a contactor and so on.

A temperature sensor 8 is arranged near the secondary battery 2 to detect a temperature of the secondary battery 2. The temperature detected by the temperature sensor 8 is sent as a temperature signal to the remaining capacity estimating unit 13 of the microcomputer 10.

The current sensor 5 is composed of a Hall current transformer (hereinafter called as a Hall CT) of a type which operates with only a single power source, for example. The current sensor 5 detects a magnetic flux generated by a current i(t) flowing through the secondary battery 2 and generates a voltage proportional to the current i(t). The voltage outputted from the current sensor 5 is sent to the first-order lag circuit 6 as a signal u(t).

As the current sensor 5, beside the Hall CT, a shunt resistor and so on can be used, which detect a magnitude of a current based on a voltage drop caused by the current flowing through a current path. But a Hall CT has an excellent feature that the Hall CT can measure a magnitude of a current without contacting the current path and a relatively large voltage can be obtained as the output. Accordingly, to use a Hall CT as the current sensor 5 is preferable.

Depending on the kind of the Hall CT, there exists a Hall CT of a type which outputs a current of a magnitude proportional to that of a current to be measured. In case of the Hall CT of this type, the same operation can be performed as that of the Hall CT of a type generating a voltage, by converting an output current to a voltage using a resistor.

The first-order lag filter 6 removes a high frequency component by filtering the signal u(t) sent from the current sensor 5 to obtain a signal uf(t), which is sent to the A/D converter 11 of the microcomputer 10. The first-order lag filter 6 is constructed so as to have a cutoff frequency lower than a sampling frequency of the A/D converter 11. The details of the first-order lag filter 6 will be described later.

The A/D converter 11 of the microcomputer 10 samples, with a definite cycle, the signal uf (t) sent from the first-order lag filter 6 to obtain a signal uf(k), which is sent to the proportional integrator 12.

The proportional integrator 12 performs a proportional integration processing for the signal uf(t) sent from the A/D converter 11. A value obtained by the proportional integration processing in the proportional integrator 12 is sent to the remaining capacity estimating unit 13 as a current integration result w(k) so as to estimate a state of charge (hereinafter called as an SOC) of the secondary battery 2.

The remaining capacity estimating unit 13 obtains a changed portion of the SOC based on the current integration result w(k) sent from the proportional integrator 12. In addition, the remaining capacity estimating unit 13 obtains an absolute value of the SOC and so on, using the changed portion of the SOC obtained as described above, the temperature of the secondary battery 2 indicated by the temperature signal sent from the temperature sensor 8, the voltage of the secondary battery 2 indicated by a voltage signal (details will be described later) sent from the voltage detecting circuit 14, and the signal uf(k) sent from the A/D converter 11. The SOC obtained in the remaining capacity estimating unit 13 is transmitted to an upper system (not shown) through a communication line.

The voltage detecting circuit 14 detects the voltage of the secondary battery 2. The voltage detected by the voltage detecting circuit 14 is sent to the remaining capacity estimating unit of the microcomputer 10 as the voltage signal.

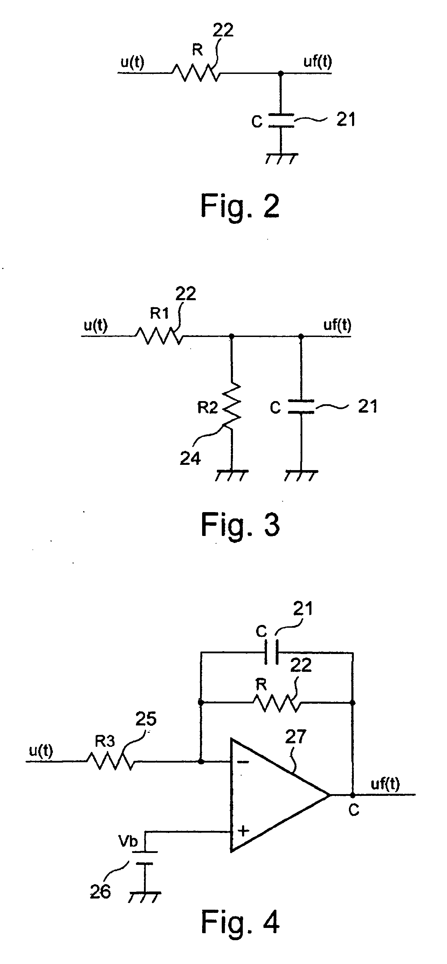

Fig. 2 is a circuit diagram showing an example of a construction of the first-order lag filter 6. The first-order lag filter 6 is composed of a resistor 22 with a resistance value R and a capacitor 21 with a capacitance value C. One end of the resistor 22 is an input terminal of the first-order lag filter 6, to which the signal u(t) sent from the current sensor 5 is inputted. The other end of the resistor 22 is earthed via the capacitor 21. The other end of the resistor 22 is an output terminal of the first-order lag filter 6, which outputs the filtered signal uf(t). A time constant $\tau$ of the first-order lag filter 6 is expressed as an expression (1) described below.

$$\tau = CR \,\, -- \,\, (1)$$

Fig. 3 is a circuit diagram showing another example of a construction of the first-order lag filter 6. The first-order lag filter 6 is composed of a resistor 23 with a resistance value R1, a resistor 24 with a resistance value R2 and the capacitor 21 with the capacitance value C. One end of the resistor 23 is an input terminal of the first-order lag filter 6, to which the signal u(t) sent from the current sensor 5 is inputted. The other end of the resistor 23 is earthed via the resistor 24 and, in addition, is earthed via the capacitor 21. The other end of the resistor 23 is an output terminal of the first-order lag filter 6, which outputs the filtered signal uf(t). The first-order lag filter 6 has an effect to make a DC gain R2/(R1 + R2), so that the first-order lag filter 6 can make an amplitude of the input to the A/D converter 11 smaller than that of the output of the current sensor 5.

In case that a shunt resistor is used as the current sensor 5, as an amplitude of the signal u(t) outputted from the current sensor 5 is very small, it is necessary to amplify the signal u(t) by the first-order lag filter 6. In this case, the first-order lag filter 6 using an operational amplifier can be used. Fig. 4 is a circuit diagram showing an example of a construction of the first-order lag filter 6 using an operational amplifier. The first-order lag filter 6 is composed of a resistor 25 with a resistance value R3, the resistor 22 with the resistance value R, the capacitor 21 with the capacitance value C, a bias voltage source 26, and an operational amplifier 27.

One end of the resistor 25 is an input terminal of the first-order lag filter 6, to which the signal u(t) sent from the current sensor 5 is inputted. The other end of the resistor 25 is connected to an inverted input terminal (-) of the operational amplifier 27. Between an output terminal and the inverted input terminal (-) of the operational amplifier 27, the capacitor 21 with the capacitance value C and the resistor 22 with the resistance value R are connected in parallel with. The other end of the operational amplifier 27 is an output terminal of the first-order lag filter 6, which outputs the filtered and amplified signal uf(t). A voltage Vb is supplied from the bias voltage source 26 to a noninverted input terminal (+) of the operational amplifier 27. As a circuit of the first-order lag filter 6 using the operational amplifier constructed as described above is generally used, so that the operation of the first-order lag filter 6 is omitted. But the time constant $\tau$ of the first-order lag filter 6 shown in Fig. 4 is made to be the same value as that of the first-order lag filter 6 shown in Fig. 2.

In addition, in case that the shunt resistor is used as the current sensor 5, as the signal u(t) sent from the current sensor 5 fluctuates in positive side and negative side according to a polarity of the current, the A/D converter 11 is required to have a function to allow a negative polarity input.

But the A/D converter 11 loaded on the microcomputer 10 can input only the signal with the positive polarity. Therefore, it is necessary to make the signal uf(t) to be inputted to the A/D converter 11 the positive polarity by adding the offset to the output of the current sensor 5. The first-order lag filter 6 shown in Fig. 4 has also a function to make the signal uf(t) the positive polarity. If the shunt resistor is used as described above, a rather complicated circuit is required compared with a simple construction shown in Fig. 2 or Fig. 3.

It may be possible to provide an A/D converter adapted to input both the signals with the positive and negative polarities, separately from the microcomputer 10. But an A/D converter which is supplied in a discrete part is relatively expensive, and there is a demerit that the circuit construction becomes complicated.

In addition, it is not necessarily required to use a Hall CT which is operable by a single voltage source. But in case that a Hall CT is a type using plus and minus power sources (not a single power source), as the signal u(t) fluctuates in the positive side or negative side according to a polarity of the current, a first-order lag filter with an operational amplifier or an A/D converter supplied in a discrete part will be required, in the same manner as in the case of using a shunt resistor.

A transfer function F(s) of the first-order lag filter 6 is expressed as a following expression (2).

$$F(s) = K/(1 + \tau s) \quad -- \quad (2)$$

Here, K indicates a gain of the first-order lag filter 6, and is equal to 1 in case of the circuit shown in Fig. 2. If expressed using the time constant $\tau$, a cutoff frequency of the first-order lag filter 6 is $1/\tau$.

A transfer function of the proportional integrator 12 is generally expressed in a discrete system so as to perform digital computation. But if the transfer function is expressed in a continuous system so as to comprehend easily, a transfer function G(s) of the proportional integrator 12 is expressed as a following expression (3).

$$G(s) = M(\omega + s)/s \quad -- \quad (3)$$

Here, M indicates a gain of the proportional integrator 12, and $\omega$ indicates a turning point frequency of the proportional integrator 12.

If the turning point frequency $\omega$ is set equal to the cutoff frequency $1/\tau$ of the first-order lag filter 6, a transfer function H(s) from the output of the current sensor 5 to the current integration result is expressed as a following expression (4), and becomes a transfer function style of the integration. In addition, it is not necessary that the turning point frequency $\omega$ of the proportional integrator 12 is strictly equal to the cutoff frequency $1/\tau$ of the first-order lag filter 6.

$$H(s) = F(s) \times G(s)$$

$$= K/(1 + \tau s) \times M(\omega + s)/s \quad -- \quad (4)$$

$$= KM/\tau s$$

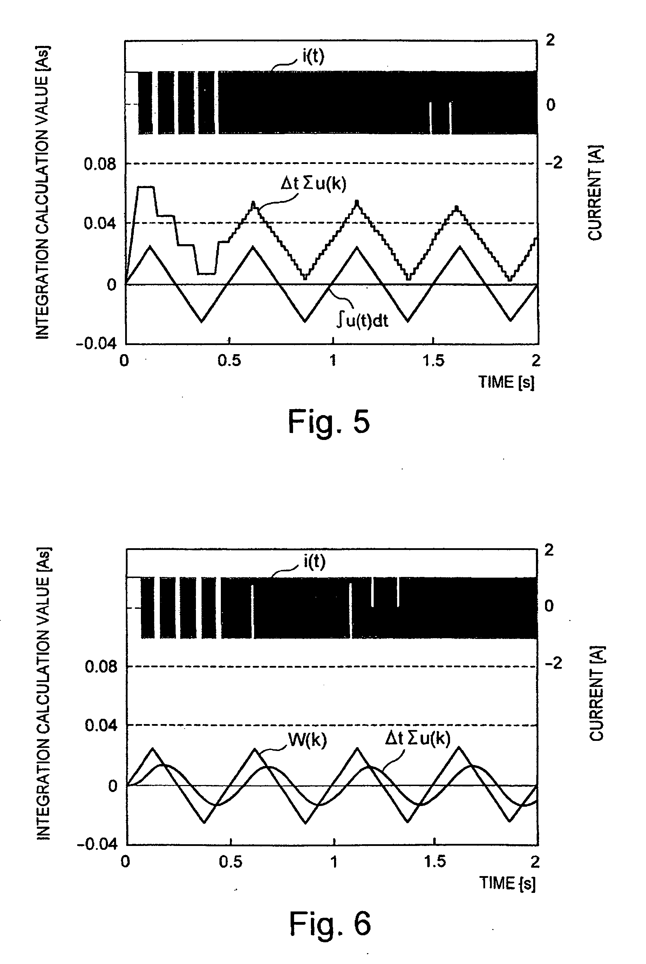

Fig. 5 is a diagram showing a conventional current integration result. Fig. 5 shows the current i(t) flowing through the secondary battery 2, a signal ∫u(t)dt obtained by integrating the signal u(t) outputted from the current sensor 5 (an ideal integration result in case that the signal u(t) not including a high frequency component is integrated), and a signal ΔtΣu(k) obtained as described below. Here, the signal u(t) outputted from the current sensor 5 is directly inputted to the A/D converter 11, and the A/D converted data is integrated to obtain the signal ΔtΣu(k). Here, Δt indicates a sampling interval of the A/D conversion.

The current i(t) is actually a current with a rectangular waveform including a high frequency component. In Fig. 5, as a frequency of the rectangular wave is so high that the current i(t) is shown partially in a straight line waveform or a waveform which is blacked out. Even if the signal u(t) including a high frequency component as described above is sampled and integrated, an error to the ideal integration result ∫u(t)dt may become large, resulting in that the integration accuracy is not obtained. This results from that a DC component is observed which does not exist intrinsically in the A/D converted data, as high frequency components are included for the sampling of the A/D conversion.

Fig. 6 shows waveforms when the above described currents are flown through the circuit shown in Fig. 1. Here, ΔtΣuf(k) shows a waveform obtained by simply integrating the signal uf(k). If only a value like an approximately average value of the signal ΔtΣuf(k) is seen, the same value as a value like an approximately average value of the true integration result ∫u(t)dt is observed, but the signal ΔtΣuf(k) is not in obsequence for the true integration result ∫u(t)dt.

On the other hand, as for the signal w(k) outputted from the proportional integrator 12, the approximately same waveform as those of the ideal integration result ∫u(t)dt shown in Fig. 5 is reproduced, and that the obsequence property is high and the error is small can be confirmed.

As the transfer function shown in the expression (3) is actually realized by the digital computation by the microcomputer 10, the transfer function receives the restriction by the sampling frequency. But by sufficiently attenuating the frequency component at the frequencies higher than the sampling frequency by the first-order lag filter 6, a uniform integration property in a range from a low frequency to the approximately sampling frequency can be obtained, and high integration accuracy and high response property can be secured.

In addition, the current integration result w(k) obtained by the above-described construction has high integration accuracy and high response property. Therefore by assuming the SOC of the secondary battery package using the current integration result w(k), an inexpensive secondary battery package in which the remaining capacity can be estimated in high accuracy.

The present invention can be used in a secondary battery package and so on in which to measure the remaining capacity accurately is required.

Obviously, numerous modifications and variations of the present invention are possible in light of the above teachings. It is therefore to be understood that within the scope of the appended claims, the invention may be practiced otherwise than as specifically described herein.

## Claims

1. A current integrating circuit device, comprising:

    a current sensor (5) to detect a current (i(t)) flowing through a current path;
    a first-order lag filter (6) to filter an output (u(t)) of the current sensor (5);
    an A/D converter (11) to convert an analog signal (uf(t)) filtered by the first-order lag filter (6) into a digital signal (uf(k)); **characterised by**
    a proportional integrator (12) to proportionally integrate the digital signal (uf(k)) outputted from the A/D converter (11).

2. The current integrating circuit device as recited in Claim 1, wherein:

    the first-order lag filter (6) has a cutoff frequency lower than a sampling frequency of the A/D converter (11).

3. The current integrating circuit device as recited in Claim 1, wherein:

    the proportional integrator (12) has a turning point frequency equal to a cutoff frequency of the A/D converter (11).

4. The current integrating circuit device as recited in any one of Claim 1 to Claim 3, wherein:

    the current sensor (5) includes a Hall CT.

5. The current integrating circuit device as recited in Claim 4, wherein:

the Hall CT is operated only by a single power source.

6. The current integrating circuit device as recited in Claim 4, wherein:

   the first-order lag filter (6) includes an input terminal, an output terminal, a resistor (22) and a capacitor (21) ;
   an end of the resistor (22) is connected to the input terminal, and another end of the resistor (22) is connected to the output terminal; and
   an end of the capacitor (21) is connected to the output terminal, and another end of the capacitor (21) is earthed.

7. The current integrating circuit device as recited in any one of Claim 1 to Claim 3, wherein:

   the current sensor (5) includes a shunt resistor.

8. The current integrating circuit device as recited in Claim 7, wherein:

   the first-order lag filter (6) includes an operational amplifier (27).

9. A secondary battery package, comprising:

   the current integrating circuit device as recited in any one of Claim 1 to Claim 8,
   a secondary battery (2) connected in series with the current sensor (5); and
   a remaining capacity estimating unit (13) configured to estimate a remaining capacity of the secondary battery (2) using a current integration result ((w(k)) obtained by the proportional integrator (12) in the current integrating circuit device.

10. The secondary battery package, as recited in Claim 9, wherein:

    the remaining capacity estimating unit (13) estimates the remaining capacity of the secondary battery (2) using a temperature of the secondary battery (2), a voltage of the secondary battery (2) and the digital signal (uf(k)) sent from the A/D converter (11), along with the current integration result ((w(k)) sent from the proportional integrator (12).

**Patentansprüche**

1. Stromintegrationsschaltungsvorrichtung, umfassend:

   einen Stromsensor (5) um einen Strom (i(t)) zu erfassen, der durch einen Strompfad fließt;
   ein Lag-Filter erster Ordnung (6) um eine Ausgabe (u(t)) des Stromsensors (5) zu filtern;
   einen A/D-Wandler (11) um ein analoges Signal (uf(t)), das von dem Lag-Filter erster Ordnung (6) gefiltert wird, in ein digitales Signal (uf(k)) zu wandeln; **gekennzeichnet durch**
   einen Proportionalintegrator (12) um das digitale Signal (uf(k)), das von dem A/D-Wandler (11) ausgegeben wird, proportional zu integrieren.

2. Stromintegrationsschaltungsvorrichtung nach Anspruch 1, wobei:

   das Lag-Filter erster Ordnung (6) eine Grenzfrequenz aufweist, die niedriger als eine Abtastfrequenz des A/D-Wandlers (11) ist.

3. Stromintegrationsschaltungsvorrichtung nach Anspruch 1, wobei:

   der Proportionalintegrator (12) eine Wendepunktfrequenz aufweist, die gleich einer Grenzfrequenz des A/D-Wandlers (11) ist.

4. Stromintegrationsschaltungsvorrichtung nach einem der Ansprüche 1 bis 3, wobei:

   der Stromsensor (5) einen Hall-CT ümfasst.

**5.** Stromintegrationsschaltungsvorrichtung nach Anspruch 4, wobei:

der Hall-CT nur von einer einzigen Leistungsquelle betrieben wird.

**6.** Stromintegrationsschaltungsvorrichtung nach Anspruch 4, wobei:

das Lag-Filter (6) erster Ordnung einen Eingangsanschluss, einen Ausgangsanschluss, einen Widerstand (22) und einen Kondensator (21) umfasst;
ein Ende des Widerstands (22) mit dem Eingangsanschluss verbunden ist und ein anderes Ende des Widerstands (22) mit dem Ausgangsanschluss verbunden ist; und
ein Ende des Kondensators (21) mit dem Ausgangsanschluss verbunden ist und ein anderes Ende des Kondensators (21) geerdet ist.

**7.** Stromintegrationsschaltungsvorrichtung nach einem der Ansprüche 1 bis 3, wobei:

der Stromsensor (5) einen Shunt-Widerstand umfasst.

**8.** Stromintegrationsschaltungsvorrichtung nach Anspruch 7, wobei:

das Lag-Filter (6) erster Ordnung einen Operationsverstärker (27) umfasst.

**9.** Akkumulatorpaket, umfassend:

die Stromintegrationsschaltungsvorrichtung nach einem der Ansprüche 1 bis 8,
einen Akkumulator (2), der seriell mit dem Stromsensor (5) verbunden ist; und
eine Verbleibende-Kapazität-Schätzeinheit (13), die konfiguriert ist, eine verbleibende Kapazität des Akkumulators (2) zu schätzen, unter Verwendung eines Stromintegrationsergebnisses ((w(k)), das durch den Proportionalintegrator (12) in der Stromintegrationsschaltungsvorrichtung erhalten wird.

**10.** Akkumulatorpaket, nach Anspruch 9, wobei:

die Verbleibende-Kapazität-Schätzeinheit (13) die verbleibende Kapazität des Akkumulators (2) schätzt, unter Verwendung einer Temperatur des Akkumulators (2), einer Spannung des Akkumulators (2) und dem digitalen Signal (uf(k)), das von dem A/D-Wandler (11) gesendet wird, zusammen mit dem Stromintegrationsergebnis ((w(k)), das von dem Proportionalintegrator (12) gesendet wird.

**Revendications**

**1.** Dispositif de circuit d'intégration de courant, comprenant :

un capteur de courant (5) pour détecter un courant (i(t)) passant à travers un chemin de courant ;
un filtre à retard du premier ordre (6) pour filtrer une sortie (u(t)) du capteur de courant (5) ;
un convertisseur A/N (11) pour convertir un signal analogique uf(t)) filtré par le filtre à retard du premier ordre (6) en un signal numérique (uf(k)) ; **caractérisé par**
un intégrateur proportionnel (12) pour intégrer proportionnellement le signal numérique (uf(k)) fourni par le convertisseur A/N (11).

**2.** Dispositif de circuit d'intégration de courant selon la revendication 1, dans lequel :

le filtre à retard du premier ordre (6) a une fréquence de coupure inférieure à une fréquence d'échantillonnage du convertisseur A/N (11).

**3.** Dispositif de circuit d'intégration de courant selon la revendication 1, dans lequel :

l'intégrateur proportionnel (12) a une fréquence de point de retournement égale à une fréquence de coupure du convertisseur A/N (11).

4. Dispositif de circuit d'intégration de courant selon l'une quelconque des revendications 1 à 3, dans lequel :

le capteur de courant (5) comprend un CT à effet Hall.

5. Dispositif de circuit d'intégration de courant selon la revendication 4, dans lequel :

le CT à effet Hall est mis en oeuvre seulement par une source d'alimentation unique.

6. Dispositif de circuit d'intégration de courant selon la revendication 4, dans lequel :

le filtre à retard du premier ordre (6) comprend une borne d'entrée, une borne de sortie, une résistance (22) et un condensateur (21) ;
une extrémité de la résistance (22) est raccordée à la borne d'entrée, et l'autre extrémité de la résistance (22) est raccordée à la borne de sortie ; et
une extrémité du condensateur (21) est raccordée à la borne de sortie, et l'autre extrémité du condensateur (21) est raccordée à la masse.

7. Dispositif de circuit d'intégration de courant selon l'une quelconque des revendications 1 à 3, dans lequel :

le capteur de courant (5) comprend une résistance de shunt.

8. Dispositif de circuit d'intégration de courant selon la revendication 7, dans lequel :

le filtre à retard du premier ordre (6) comprend un amplificateur opérationnel (27).

9. Ensemble de batterie secondaire, comprenant:

le dispositif de circuit d'intégration de courant selon l'une quelconque des revendications 1 à 8,
une batterie secondaire (2) montée en série avec le capteur de courant (5) ; et
une unité d'estimation de capacité restante (13) configurée pour estimer la capacité restante de la batterie secondaire (2) utilisant un résultat d'intégration de courant ((w(k)) obtenu par l'intégrateur proportionnel (12) dans le dispositif de circuit d'intégration de courant.

10. Ensemble de batterie secondaire, selon la revendication 9, dans lequel:

l'unité d'estimation de capacité restante (13) estime la capacité restante de la batterie secondaire (2) en utilisant une température de la batterie secondaire (2), une tension de la batterie secondaire (2) et le signal numérique (uf(k)) envoyé par le convertisseur A/N (11), ainsi que le résultat d'intégration de courant ((w(k)) envoyé par l'intégrateur proportionnel (12).

Fig. 1

Fig. 2

Fig. 3

Fig. 4

Fig. 5

Fig. 6

Fig. 7

EP 2 233 934 B1

Fig. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP PH526987 B
- JP PH11135156 B
- JP 2006300728 B
- EP 1736789 A1